# EUROPÄISCHE PATENTANMELDUNG

(11) **EP 1 561 836 A1**
(43) Veröffentlichungstag der Anmeldung: **10.08.2005**
(21) Anmeldenummer: 05002399.3
(22) Anmeldetag: 04.02.2005
(51) Int. Cl.: C23C 14/34, H01J 37/34

(54) **Verfahren zum Herstellen einer Targetanordnung**

(30) Priorität: 05.02.2004 DE 102004005663
(71) Anmelder: Zentrum Für Material- und Umwelttechnik Gmbh, 09599 Freiberg (DE)
(72) Erfinder: Hüttl, Grit, Dr., 09599 Freiberg (DE); Klemm, Jens, 09599 Freiberg (DE); Menzel, Hans-Ulrich, Dr., 09599 Freiberg (DE); Möhler, Wolfram, Dr., 09599 Freiberg (DE); Wagner, Joachim, 09599 Freiberg (DE)
(74) Vertreter: Manitz, Finsterwald & Partner GbR

(57) **Zusammenfassung**

Bei einem Verfahren zum Herstellen einer Targetanordnung wird zwischen einem Trägerelement und einem Target ein Pressteil plastisch verformt.

## Beschreibung

Die vorliegende Erfindung betrifft ein Verfahren zum Herstellen einer Targetanordnung mit einem zylindrischen Trägerelement und mindestens einem ein Targetmaterial aufweisenden hohlzylindrischen Target, wobei das Target, welches das Trägerelement zumindest abschnittweise umgibt, an dem Trägerelement befestigt wird.

Derartige Herstellungsverfahren zur Herstellung von Targetanordnungen, die auch als Zerstäubungstargets oder Sputtertargets bezeichnet werden, sind grundsätzlich bekannt. Derartige Targets werden als Materialquelle beispielsweise bei der Dünnbeschichtung von großflächigen Substraten mittels Kathodenzerstäubung oder Sputtern eingesetzt. Die Dünnbeschichtung mittels dieser Verfahren wird beispielsweise für die Herstellung von Wärmeschutz- oder Sonnenschutzschichten auf Flachglas oder Kunststofffolien angewandt.

Problematisch gestaltet sich bei den bekannten Targetanordnungen die Befestigung des Targets am Trägerelement. So sind beispielsweise aus dem Stand der Technik (vgl. DE 44 14 470 A1 oder EP 0 336 618 A2) Anordnungen bekannt, bei denen das Target mit Hilfe von elastisch federnden Klemmelementen an dem Trägerelement befestigt wird. Eine derartige Befestigung ist jedoch nicht immer zufrieden stellend, insbesondere, wenn eine feste Verbindung und eine gute Wärmeableitung zwischen Target und Trägerelement gefordert wird.

Es ist die Aufgabe der vorliegenden Erfindung, ein Verfahren zum Herstellen einer Targetanordnung zu schaffen, mit dem eine ausreichend feste Verbindung zwischen Trägerelement und Target erzielt werden kann, die einen guten Wärmeübergang gewährleistet.

Die Lösung dieser Aufgabe erfolgt erfindungsgemäß dadurch, dass zwischen dem Trägerelement und dem Target ein plastisch verformbares Pressteil angeordnet wird, wobei das Pressteil plastisch, d.h. irreversibel verformt wird, so dass Trägerelement und Target kraftschlüssig miteinander verpresst sind.

Durch das erfindungsgemäß Verfahren lässt sich eine nicht lösbare Verbindung zwischen Trägerelement und Target herstellen, die einen guten Wärmeübergang sicherstellt. Hierbei eignen sich als Pressteil duktile Werkstoffe wie z.B. Cu, Al, Zn, Sn oder deren Legierungen, wobei diese Werkstoffe den weiteren Vorteil aufweisen, dass sie gute Wärmeleitungseigenschaften aufweisen. Durch das erfindungsgemäße Verfahren ergibt sich der Vorteil, dass die endgültige Verbindung erst dann vorgenommen werden kann, wenn alle Targetelemente ordnungsgemäß auf dem Trägerelement ausgerichtet sind.

Vorteilhafte Ausführungsformen der Erfindung sind in der Beschreibung, der Zeichnung sowie den Unteransprüchen beschrieben.

Nach einer ersten vorteilhaften Ausführungsform kann das Verpressen dadurch erfolgen, dass als Pressteil ein Hohlprofil verwendet wird, das im Inneren mit Fluiddruck beaufschlagt und dadurch aufgeweitet wird. Bei dieser Ausführungsform wird durch das Aufweiten des Hohlprofils zwischen Trägerelement und Target eine hochfeste, kraftschlüssige Verbindung hergestellt. Durch Einbringen von Profilierungen oder Nuten an Trägerelement und/oder Target kann nach dem Aufweiten zusätzlich eine formschlüssige Verbindung geschaffen werden. Wenn keine Nuten oder Aussparungen vorgesehen sind, ergibt sich der Vorteil größerer Stabilität.

Nach einer weiteren vorteilhaften Ausführungsform können mehrere axial oder radial zueinander beabstandete Pressteile plastisch verformt werden. Eine besonders vorteilhafte Ausführungsform ergibt sich, wenn das Pressteil am Außenumfang des Trägerelementes mäanderförmig angeordnet oder schraubenförmig an dem Trägerelement angeordnet wird. Besonders vorteilhaft ist es, das Pressteil schraubenlinienförmig auf das Trägerelement aufzuwickeln. In allen Fällen kann es vorteilhaft sein, das Pressteil vor dem Verpressen an dem Trägerelement beispielsweise durch Verkleben zu fixieren.

Zusätzlich zu der kraftschlüssigen und der optional vorgesehenen formschlüssigen Verbindung kann auch eine stoffschlüssige Verbindung vorgesehen werden. So ist es beispielsweise möglich, zwischen Pressteil und Trägerelement und/oder Target eine Lötverbindung herzustellen, indem ein gezielter Wärmeeintrag erfolgt. Durch Vorsehen von geeignetem Lotwerkstoff an den Grenzflächen zwischen Trägerelement, Pressteil und Target kann hierdurch zusätzlich zu dem Verpressen auf einfache Weise eine Lötverbindung hergestellt werden.

Zur Verbesserung des Verbindungsprozesses und zur gleichmäßigen Spannungsverteilung im Bereich des Presselementes oder der Presselemente kann das Target an seinem Innenumfang metallisiert oder mit einer geeigneten Auskleidung, beispielsweise einer metallisierten Faserstruktur, versehen werden. Gleichzeitig kann dadurch ein Abplatzen von aus Keramik bestehendem Targetgrundmaterial vermieden werden.

Eine besonders vorteilhafte Verwendung einer erfindungsgemäß hergestellten Targetanordnung ergibt sich, wenn als Presselement ein Hohlprofil verwendet wird und nach dem Herstellen der Verbindung zwischen Trägerelement und Targetanordnung, d.h. im Betrieb, ein Kühlfluid durch das Hohlprofil geleitet wird, um die Targetanordnung zu kühlen.

Das erfindungsgemäße Verfahren bzw. die mit dem erfindungsgemäßen Verfahren hergestellte Targetanordnung zeichnet sich durch geringe Materialkosten und gute Handhabung aus. Es können beliebig lange Rohrtargets hergestellt werden und der Wärmeübergang zwischen Target und Trägerelement ist durch geeignete Gestaltung bzw. Anordnung des Presselementes einstellbar. Durch die Verwendung von metallischen Presselementen kann eine elektrisch und thermisch leitende Verbindung zwischen dem Trägerelement und der Targetanordnung hergestellt werden. Schließlich können die Maßanforderungen an Trägerelement und Target reduziert werden, da eventuelle Toleranzen durch das Verpressen des Presselementes ausgeglichen werden können.

Das Target kann grundsätzlich aus einem gepressten oder einem gepressten und gesinterten Targetmaterial bestehen. Wegen der mechanischen Verbindung von Target und Trägerelement eignet sich die Targetanordnung besonders gut für solche Targetmaterialien, die beim Gießen oder thermischen Spritzen sublimieren würden, wie beispielsweise ZnO. Alternativ kann das Target auch aus gegossenen Targetmaterialien bestehen.

Darüber hinaus kann das Targetmaterial als thermische Spritzschicht oder als elektrochemisch abgeschiedene Schicht auf einen hohlzylindrischen Grundkörper aufgebracht sein. Als Targetmaterialien eignen sich Keramiken oder Metalllegierungen, beispielsweise Chromlegierungen.

Das Trägerelement kann beispielsweise aus Titan, Stahl oder Kupfer bestehen.

Schließlich muss weder das Trägerelement noch das Target ein vollständig geschlossener hohlzylindrischer Körper sein, auch wenn dies in vielen Anwendungsfällen aus Stabilitätsgründen vorteilhaft ist. Es eignen sich in gleicher Weise auch zylindrische Trägerelemente und Targets, die in axialer Richtung geschlitzt sind oder Aussparungen aufweisen. Auch ist es nicht erforderlich, dass das Trägerelement ein Vollzylinder ist. Vielmehr ist eine hohlzylindrische Anordnung bevorzugt. Als Targets werden bevorzugt kreiszylindrische Targetsegmente verwendet.

Nachfolgend wird die vorliegende Erfindung rein beispielhaft anhand einer vorteilhaften Ausführungsform unter Bezugnahme auf die beigefügten Zeichnungen beschrieben. Es zeigen:
- Fig. 1: eine schematische Querschnittsansicht durch eine Targetanordnung vor dem Verpressen; und
- Fig. 2: eine der Fig. 1 entsprechende Ansicht nach dem Verpressen von Trägerelement und Target.

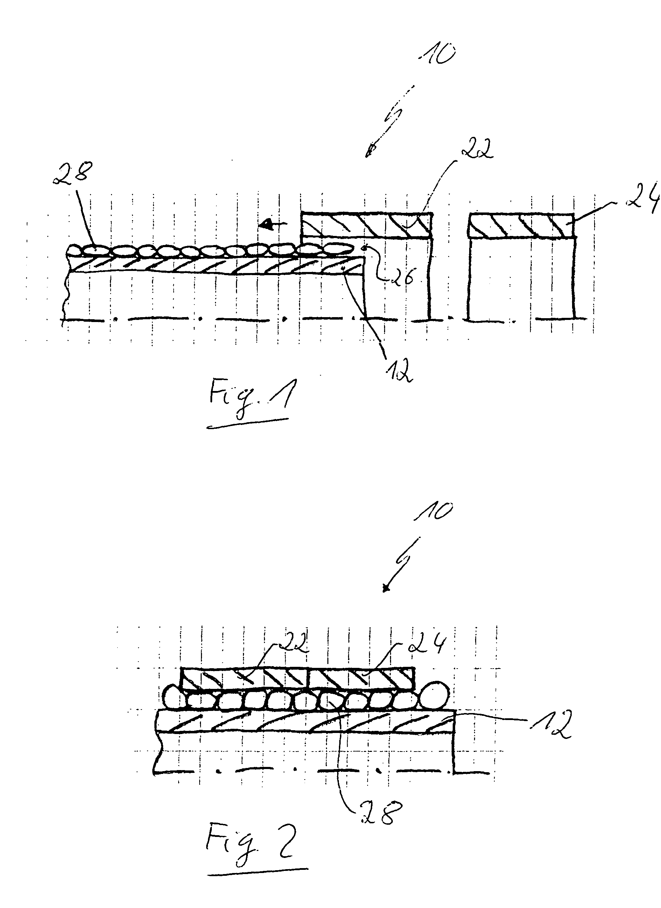

Fig. 1 zeigt eine Targetanordnung 10 mit einem hohlzylindrischen Trägerelement 12 und mehreren hohlzylindrischen Targets 22, 24, wobei die Targets 22 und 24 an ihrem Außenumfang mit Targetmaterial versehen sind oder insgesamt aus Targetmaterial bestehen.

Wie Fig. 1 zeigt, ist der Außenumfang des Trägerelementes 12 geringer als der Innenumfang der Targets 22, 24, so dass zwischen den Targets und dem Trägerelement ein Ringspalt 26 vorhanden ist, wenn die hohlzylindrischen Targets über das Trägerelement geschoben werden, wie dies in der Figur mit einem Pfeil angedeutet ist.

Auf den Außenumfang des Trägerelementes 12 ist ein Pressteil 28 schraubenförmig aufgewickelt, wobei die einzelnen Windungen dicht aneinander liegen. Bei dem dargestellten Ausführungsbeispiel handelt es sich bei dem Pressteil um ein Kupfer-Flachrohr, das an seinem einen Ende mit einem entlüftbaren Verschluss und an seinem anderen Ende mit einer Hydraulikverschraubung versehen ist. Durch Anschließen der Hydraulikverschraubung an eine Druckquelle kann das Pressteil im Inneren mit Fluiddruck beaufschlagt, dadurch aufgeweitet und plastisch verformt werden, so dass dieses den Ringspalt 26 vollständig ausfüllt und eine kraftschlüssige Verbindung zwischen Trägerelement 12 und den Targets 22, 24 herstellt.

Zur Herstellung der in Fig. 2 dargestellten Targetanordnung wird zunächst das Pressteil 28 wie dargestellt auf das Trägerelement 12 aufgewickelt. Anschließend werden die beiden Targets 22 und 24 in Pfeilrichtung über die Anordnung aus Trägerelement und Pressteil geschoben, wobei die Dimensionierungen so gewählt sein können, dass hierbei bereits ein gewisser Reibschluss vorliegt.

Nach diesem Schritt wird das Innere des Pressteils 28 mit Fluiddruck beaufschlagt, wodurch sich das Hohlprofil aufweitet und eine kraftschlüssige Pressverbindung zwischen Trägerelement und Targets hergestellt wird.

Wie Fig. 2 zeigt, erstreckt sich das Pressteil 28 in Axialrichtung auch noch etwas über die Axialerstreckung der beiden Targets 22 und 24 hinaus. Hierdurch wird erreicht, dass sich das rohrförmige Pressteil 28 im Bereich der äußeren Enden der Targets 22 und 24 stärker aufweitet, so dass auch in Axialrichtung eine Fixierung der Targets gewährleistet ist.

Bei dem oben beschriebenen Ausführungsbeispiel wurde ein Kupferrohr mit einem Durchmesser von 3,4 mm und einer Wandstärke von 0,4 mm auf etwa 1,7 mm flachgedrückt. Dieses Flachrohr wurde, wie in Fig. 1 gezeigt, auf ein Trägerelement mit einem Außendurchmesser von 139,5 mm aufgewickelt. Der Innendurchmesser der Targets 22 und 24 betrug 143,5 mm, so dass sich ein Ringspalt in der Größenordnung von 2 mm ergab. Durch Druckbeaufschlagung des Pressteils 28 mit einem Druck in der Größenordnung von etwa 200 bis 300 bar konnte eine hervorragende Verbindung zwischen Trägerelement und Targets erzielt werden.

### Bezugszeichenliste

- 10: Targetanordnung
- 12: Trägerelement
- 22, 24: Target
- 26: Ringspalt
- 28: Pressteil

## Patentansprüche

1. Verfahren zum Herstellen einer Targetanordnung (10) mit einem zylindrischen Trägerelement (12) und mindestens einem ein Targetmaterial aufweisenden hohlzylindrischen Target (22, 24), wobei das Target (22, 24), welches das Trägerelement (12) zumindest abschnittsweise umgibt, an dem Trägerelement (12) befestigt wird, bei welchem Verfahren:
- zwischen dem Trägerelement (12) und dem Target (22, 24) ein plastisch verformbares Pressteil (28) angeordnet wird, und
- das Pressteil (28) plastisch verformt wird, so dass Trägerelement (12) und Target (22, 24) kraftschlüssig miteinander verpresst sind.

2. Verfahren nach Anspruch 1,
**dadurch gekennzeichnet,**
**dass** das Verpressen **dadurch** erfolgt, dass als Pressteil ein Hohlprofil (28) verwendet wird, das im Inneren mit Fluiddruck beaufschlagt und **dadurch** aufgeweitet wird.

3. Verfahren nach Anspruch 1 oder 2,
**dadurch gekennzeichnet,**
**dass** mehrere axial oder radial zueinander beabstandete Pressteile plastisch verformt werden.

4. Verfahren nach einem der vorherigen Ansprüche,
**dadurch gekennzeichnet,**
**dass** das Pressteil mäanderförmig am Außenumfang des Trägerelementes angeordnet wird.

5. Verfahren nach einem der vorherigen Ansprüche,
**dadurch gekennzeichnet,**
**dass** das Pressteil (28) schraubenlinienförmig angeordnet wird und insbesondere auf das Trägerelement aufgewickelt wird.

6. Verfahren nach einem der vorherigen Ansprüche,
**dadurch gekennzeichnet,**
**dass** zusätzlich zu dem Verpressen eine stoffschlüssige Verbindung, insbesondere eine Lötverbindung, zwischen Pressteil (28) und Trägerelement (12) und/ oder Target (22, 24) hergestellt wird.

7. Verfahren nach einem der vorherigen Ansprüche,
**dadurch gekennzeichnet,**
**dass** die Verbindung von Trägerelement und Target unter Zuführen von Wärme erfolgt.

8. Verfahren nach einem der vorherigen Ansprüche,
**dadurch gekennzeichnet,**
**dass** für das Pressteil (28) ein elektrisch leitendes Material verwendet wird.

9. Verfahren nach einem der vorherigen Ansprüche,
**dadurch gekennzeichnet,**
**dass** das Target an seiner Innenmantelfläche vor dem Verpressen metallisiert wird.

10. Targetanordnung hergestellt nach zumindest einem der vorherigen Ansprüche.

11. Verwendung einer Targetanordnung nach Anspruch 10 sofern abhängig von Anspruch 2,
**dadurch gekennzeichnet,**
**dass** durch das Hohlprofil (28) ein Kühlfluid geleitet wird, um die Targetanordnung (10) zu kühlen.
